# EUROPÄISCHE PATENTSCHRIFT

(11) **EP 1 661 168 B1**
(45) Veröffentlichungstag und Bekanntmachung des Hinweises auf die Patenterteilung: **22.10.2014**
(21) Anmeldenummer: 04766284.6
(22) Anmeldetag: 21.07.2004
(51) Int. Cl.: H01L 49/02, H01L 21/316, H01L 23/522, H01L 27/01, H01L 27/08

(54) **Herstellungsverfahren für eine Integrierte Schaltungsanordnung mit Kondensator**
Manufacturing method of an integrated circuit with a capacitor
Procédé de fabrication d'un circuit intégré comprenant un condensateur

(30) Priorität: 05.09.2003 DE 10341059
(43) Veröffentlichungstag der Anmeldung: 31.05.2006
(73) Patentinhaber: Infineon Technologies AG, 85579 Neubiberg (DE)
(72) Erfinder: GÖBEL, Thomas, 81377 Muenchen (DE); HELNEDER, Johann, 85652 Landsham (DE); KÖRNER, Heinrich, 83052 Bruckmühl (DE); MITCHELL, Andrea, 81373 Muenchen (DE); SCHWERD, Markus, 83607 Holzkirchen (DE); SECK, Martin, 81827 München (DE); TORWESTEN, Holger, 85579 Neubiberg (DE)
(74) Vertreter: Kindermann, Peter
(86) Internationale Anmeldenummer: PCT/EP2004/051570
(87) Internationale Veröffentlichungsnummer: WO 2005/024913

(56) Entgegenhaltungen:
- EP-A- 1 217 658
- US-A- 3 781 610
- US-A- 4 344 223
- US-A- 4 450 048
- US-A- 5 838 035
- US-A- 5 893 731
- US-A- 6 066 868
- US-A1- 2001 041 413
- US-A1- 2002 020 836
- US-B1- 6 613 641

## Beschreibung

Die Erfindung betrifft ein Herstellungsverfahren für eine integrierte Schaltungsanordnung mit einem Kondensator, der in der folgenden Reihenfolge enthält:
- eine elektrisch leitfähige Grundelektrode aus einem Metall oder einer Metalllegierung, insbesondere aus Ventilmetall oder aus einer Ventilmetalllegierung,
- ein auf die Grundelektrode aufgewachsenes Dielektrikum aus einem Oxid eines in der Grundelektrode enthaltenen Materials,
- und eine elektrisch leitfähige Deckelektrode.

Der Begriff Ventilmetall betrifft dabei eine Metall in das insbesondere bei einer anodischen Oxidation Material eindringt und aus dem dabei kein Material austritt.

Das Dielektrikum grenzt direkt an die Grundelektrode an. Üblicherweise grenzt das Dielektrikum auch direkt an die Deckelektrode an.

Die Erfindung ist insbesondere für die simultane Herstellung eines Dünnfilmwiderstand aus dem Material der Grund- oder der Deckelektrode gleichzeitig mit der Herstellung des Kondensators geeignet. Alternativ sollen sowohl in der Lage bzw. Ebene der Grundelektrode als auch in der Lage bzw. Ebene der Deckelektrode Widerstände angeordnet werden.

Zum Aufwachsen des Oxids wird eine anodische Oxidation verwendet, die mit Hilfe eines fotolithografisch strukturierten Resists auf einem Teil einer Grundelektrodenschicht begrenzt wird, aus der später die Grundelektrode erzeugt wird. Geeignete Ventilmetalle für eine anodische Oxidation sind beispielsweise Tantal oder Titan.

Die US 6,613,641 B1, Figur 7, zeigt die Herstellung eines MIM-Kondensators durch Anodisieren. Aus der US 2002/0020836 A1 ist ein Dünnfilm-Kondensator bekannt. Der Kondensator hat eine Grundelektrode aus Kupfer, Silber oder Aluminium und ein abgeschiedenes Dielektrikum aus bspw. Titanoxid oder Tantaloxid. Das Dielektrikum grenzt an eine dielektrische Schicht an. Aus der US 2001/0041413 A1 ist ein Verfahren zum Herstellen eines elektronischen Bauteils mit Kondensator und Widerstand bekannt. Der Widerstand enthält Tantaloxynitrid und der Kondensator enthält Tantalpentoxid als Dielektrikum. Das Dielektrikum des Kondensators wird durch CVD-Abscheidung einer Tantaloxidschicht auf einer Aluminiumschicht, die auch als Grundelektrodenschicht bezeichnet werden kann, und anschließende Oxidation des Tantaloxids zu Tantalpentoxid erzeugt.

Aus der US 5,838,035 ist eine Barriereschicht eines ferroelektrischen Kondensators bekannt. Aus der US 3, 781, 610 ist ein Schaltkreis basierend auf Dünnfilmtechnik bekannt, der Kondensatoren und Widerstände enthält.

Aus der US 5,893,731 ist ein Schaltkreis mit einer Kombination aus Widerstand und Kondensator bekannt. Aus dem Dokument EP 1 217 658 A2 ist ein ferroelektrischer PZT-Kondensator bekannt. Aus der US 6,066,868 ist ein ferroelektrischer Speicher bekannt.

Aus der US 4,344,223 ist ein hybrider integrierter Schaltkreis mit Kondensator und Widerstand bekannt. Aus der US 4,450,048 ist ein Verfahren zum Herstellen eines integrierten Schaltkreises mit Kondensator bekannt, der ein durch anodische Oxidation erzeugtes Dielektrikum enthält.

Es ist Aufgabe der in Anspruch 1 definierten Erfindung, ein Herstellungsverfahren für eine einfach aufgebaute integrierte Schaltungsanordnung mit Kondensator anzugeben, insbesondere mit simultan prozessiertem Kondensator und Dünnfilmpräzisionswiderstand, wobei der Kondensator oder beide Bauelemente und damit auch die integrierte Schaltungsanordnung insbesondere gute elektrische Eigenschaften haben.

Die Erfindung geht insbesondere von der Überlegung aus, dass die zum Aufwachsen mit anodischer Oxidation geeigneten Ventilmetalle mit einer Vielzahl von chemischen Substanzen reagieren, die bei der Herstellung von integrierten Schaltkreisen eingesetzt werden, beispielsweise mit dem flüssigen oder dem festen Material einer Resistschicht, insbesondere eines Fotolacks, oder mit Flüssigkeiten, die zum Entwickeln einer Resistschicht genutzt werden. Andererseits geht die Erfindung insbesondere von der Überlegung aus, dass das Aufwachsen des Kondensatordielektrikums mit hoher Qualität, d.h. eines Dielektrikums mit kleinen Leckströmen, nur dann gewährleistet ist, wenn die Oberfläche des Metalls, insbesondere des Ventilmetalls, noch nicht mit Lack oder Entwickler reagiert hat.

Deshalb wird beim erfindungsgemäßen Herstellen der integrierten Schaltungsanordnung eine elektrisch isolierende Grundschicht verwendet, die direkt an die Grundelektrode grenzt. Damit kann Resist, das zum Festlegen des Gebietes für das Aufwachsen benutzt wird, nicht direkt an die Ventilmetalllegierung gelangen, sondern liegt auf der Grundschicht auf, die in diesem Fall die Funktion einer Schutzschicht hat. Damit gelangt weder flüssiges Resist noch Entwickler zum Entwickeln des Resists an das Metall der Grundelektrode.

Die elektrisch isolierende Grundschicht enthält eine an das Dielektrikum angrenzende Aussparung. Diese Aussparung wurde unter Nutzung des entwickelten Resists erzeugt, wobei die Grundschicht im Bereich der Aussparung entfernt worden ist, so dass die Grundelektrodenschicht im Bereich der Aussparung freigelegt wurde. Anschließend wurde in der Aussparung das Dielektrikum aufgewachsen, nämlich durch anodische Oxidation, so dass ein Dielektrikum gebildet worden ist, das die Aussparung füllt und damit an den Rändern der Aussparung an die Grundschicht angrenzt.

Die integrierte Schaltungsanordnung enthält bei einer Ausgestaltung außerdem eine auf der Grundschicht und auf der Deckelektrode angeordnete dielektrische Schicht, die üblicherweise nach dem Strukturieren der Deckelektrode und nach dem Entfernen der Reste einer zum Erzeugen der Deckelektrode dienenden Resistschicht abgeschieden wird. Die dielektrische Schicht besteht aus dem gleichen Material wie die Grundschicht, wenn auch die dielektrische Schicht als Schutzschicht oder als Ätzstoppschicht genutzt wird. Die dielektrische Schicht besteht aus einem anderen Material als die Grundschicht, wenn keine weitere Schutzschicht oder Ätzstoppschicht benötigt wird. Wird keine weitere Schutzschicht oder Ätzstoppschicht verwendet, so ist ein Intralayerdielektrikum ein geeignetes Material für die dielektrische Schicht, bspw. ein Oxid, insbesondere Siliziumdioxid. Als Material für die Grundschicht bzw. für eine als Schutzschicht bzw. als Ätzstoppschicht dienende dielektrische Schicht ist insbesondere ein Nitrid geeignet, insbesondere Siliziumnitrid.

Bei der erfindungsgemäßen hergestellten Schaltungsanordnung ist die Grundschicht dünner als das Dielektrikum. Das Dielektrikum ist an seinem Rand abgestuft, wobei eine parallel zur Grundelektrode liegende Stufenfläche mit dem grundelektrodenfernen Rand der Aussparung vorzugsweise in einer Ebene liegt. Durch diese Maßnahme ist einerseits gewährleistet, dass die Deckelektrode vollständig strukturiert ist. Andererseits ist gewährleistet, dass das Dielektrikum gleichzeitig mit der Deckelektrode nicht vollständig strukturiert worden ist. Insbesondere lassen sich bei diesem Vorgehen an den Seiten des Dielektrikums Polymere vermeiden, die unter Einschluss von elektrisch leitfähigen Verbindungen einen Kontakt oder eine Kriechstrecke zwischen der Grundelektrode und der Deckelektrode herstellen würden.

Bei einer nächsten Weiterbildung wird als Metall eines der folgenden Ventilmetalle benutzt: Tantal, Titan, Niob, Zirkonium oder Hafnium. Insbesondere die beiden zuerst genannten Metalle sind Metalle, deren Eigenschaften bei der Herstellung integrierter Schaltungsanordnungen bereits ausgiebig untersucht worden sind. Die Prozesse zum Abscheiden von Schichten dieser Metalle werden gut beherrscht.

Bei einer alternativen Weiterbildung wird eine Ventilmetalllegierung verwendet, die aus einem Ventilmetallnitrid besteht oder ein Ventilmetallnitrid enthält. Insbesondere die eben genannten Ventilmetalle werden eingesetzt. Bei einer Ausgestaltung wird Tantalnitrid als Ventilmetallnitrid genutzt. Tantalnitrid hat einen sehr kleinen Temperaturkoeffizienten, so dass aus der Grundelektrodenschicht und/oder Deckelektrodenschicht auch Präzisionswiderstände gefertigt werden können, die in der gleichen integrierten Schaltungsanordnung angeordnet sind wie der Kondensator. Das Tantal und das Nitrid sind bei einer Ausgestaltung im stöchiometrischen Verhältnis vorhanden. Bei einer alternativen Ausgestaltung liegen Tantal und Stickstoff in der Ventilmetalllegierung in einem nichtstöchiometrischen Verhältnis vor.

Ähnlich gute elektrische Eigenschaften wie Tantalnitrid hat Tantalsilizid. Somit werden auch Ventilmetallsilizide eingesetzt. Das Ventilmetall und das Silizid liegen insbesondere in einem stöchiometrischen Verhältnis oder in einem nichtstöchiometrischen Verhältnis vor.

Gemäß der Erfindung ist das Dielektrikum ein durch anodische Oxidation erzeugtes Dielektrikum. Durch die Einstellung von Spannungs- und Stromwerten bei der anodischen Oxidation lässt sich der Wachstumsprozess und damit die Kondensatordielektrikumsdicke sehr genau steuern und einstellen.

Außerdem bildet sich aufgrund der anodischen Oxidation ein besonders hochwertiges Dielektrikum, das insbesondere nur einen kleinen Leckstrom verursacht. Als Dielektrikum ist insbesondere Tantalpentoxid Ta₂O₅ geeignet. Tantalpentoxid hat eine große Dielektrizitätskonstante, die wesentlich größer als 7 ist, d.h. als bei heute üblichen Kondensatoren mit Siliziumnitrid.

Bei einer nächsten Weiterbildung der Schaltungsanordnung hat die Deckelektrode eine andere stoffliche Zusammensetzung als die Grundelektrode. Bei der Auswahl des Materials für die nicht als Präzisionswiderstand genutzte Elektrodenebene lassen sich Materialien mit einer sehr hohen Leitfähigkeit verwenden, die aber beispielsweise einen höheren Temperaturkoeffizienten haben als das Material der anderen Elektrodenebene.

Bei einer nächsten Weiterbildung ist die Grundelektrode außerhalb einer Metallisierungslage angeordnet, die Leitbahnen enthält, d.h. insbesondere in einer Via-Ebene, in der mehr Platz für den Kondensator vorhanden ist, als in einer Leitbahnebene. In einer Leitbahn wird Strom auch parallel zu einer Hauptfläche eines Substrats der integrierten Schaltungsanordnung transportiert, in dem eine Vielzahl von integrierten Halbleiterbauelementen angeordnet sind. Das Halbleitersubstrat ist beispielsweise ein Siliziumsubstrat. Im Gegensatz dazu leitet ein Via den Strom in Normalenrichtung oder entgegen der Normalenrichtung der Hauptfläche des Substrats.

Bei einer nächsten Weiterbildung enthält eine an der vom Dielektrikum abgewandten Seite der Grundelektrode angeordnete und der Grundelektrode benachbarte Metallisierungslage Leitbahnen aus Kupfer oder einer Kupferlegierung. Alternativ ist die auf der dem Dielektrikum abgewandten Seite der Grundelektrode angeordnete und der Grundelektrode benachbarte Metallisierungslage eine Metallisierungslage, die Leitbahnen aus Aluminium oder aus einer Aluminiumlegierung enthält. Alternativ lassen sich aber auch andere Materialien, z.B. Gold, Silber bzw. Wolfram, und Aufbringungsverfahren nutzen. Vor der Herstellung des Kondensators lassen sich also Metallisierungslagen mit einem Einfach-Damascene-Verfahren oder mit einem dualen-Damascene-Verfahren herstellen. Alternativ lassen sich aber auch ganzflächig metallische Schichten abscheiden und danach strukturieren. Unabhängig von dem Material der substratnahen Metallisierungslage, auf der der Kondensator erzeugt worden ist, lässt sich der Kondensator direkt über einer Leitbahn der darunterliegenden Metallisierungslage anschließen, so dass die Leitbahn als elektrisch leitfähiger Anschluss für die Grundelektrode dient.

Alternativ wird zwischen der Grundelektrode und der darunterliegenden Leitbahnebene eine Isolierschicht angeordnet oder der Bereich unterhalb der Grundelektrode ist in der darunterliegenden Metallisierungslage mit Zwischenleitbahn-Isoliermaterial gefüllt. In diesem Fall muss die Grundelektrode "von oben" angeschlossen werden, so dass der Anschluss oder die Anschlüsse zum Anschließen der Grundelektrode an der dem Dielektrikum zugewandten Seite der Grundelektrode angeordnet sind. Die Deckelektrode wird in beiden Fällen von "oben" angeschlossen.

Bei einer nächsten Weiterbildung ist in der Ebene, in der die Grundelektrode angeordnet ist, auch ein Widerstand aus dem gleichen Material wie die Grundelektrode angeordnet. Der Widerstand ist vorzugsweise ein Präzisionswiderstand mit einem Temperaturkoeffizienten kleiner als 10⁻⁴ K⁻¹ (1/Kelvin) bzw. 10⁻⁴ °C⁻¹ (1/Grad Celsius). Präzisionswiderstände besonderer Güte haben sogar Temperaturkoeffizienten kleiner als 10⁻⁵/Kelvin. Durch die gleichzeitige Herstellung von Präzisionswiderständen und Grundelektroden von Kondensatoren in einer Ebene lassen sich diese Bauelemente mit einer kleinen Anzahl von Prozessschritten erzeugen.

Die Erfindung betrifft ein Verfahren zum Herstellen eines Kondensators, insbesondere eines Kondensators in einer integrierten Schaltungsanordnung oder einer deren Weiterbildungen. Bei dem erfindungsgemäßen Verfahren werden u.a. die folgenden Verfahrensschritte ausgeführt:
- Erzeugen einer elektrisch leitfähigen Grundelektrodenschicht,
- Erzeugen einer Schutzschicht nach dem Erzeugen der Grundelektrodenschicht, wobei die Grundelektrodenschicht noch unstrukturiert ist,
- Aufbringen einer Resistschicht auf die Grundschicht, wobei die Grundschicht noch unstrukturiert ist,
- selektives Bestrahlen und Entwickeln der Resistschicht,
- Strukturieren der Grundschicht mit der entwickelten Resistschicht, wobei die Grundelektrodenschicht in mindestens einem Bereich gemäß der entwickelten Resistschicht freigelegt wird, d.h. die Grundelektrodenschicht wird nur angeätzt, jedoch nicht vollständig strukturiert,
- Durchführen einer anodinten Oxidation der Grundelektrodenschicht in mindestens einem freiliegenden Bereich der Grundelektrodenschicht nach dem Strukturieren der Schutzschicht.

Bei dem erfindungsgemäßen Verfahren verhindert die Grundschicht, dass das Material der Grundelektrodenschicht vor dem Erzeugen des Dielektrikums, insbesondere vor dem Durchführen der Oxidation, bereits mit chemischen Substanzen reagiert, die bei der Herstellung des Kondensators verwendet werden, insbesondere mit flüssigem Fotolack oder mit Entwickler für den Fotolack. Dadurch lässt sich ein Oxid hoher Qualität erzeugen.

Die Oxidation ist eine anodische Oxidation, die vorzugsweise vor dem Entfernen von nach dem Entwickeln verbliebenen Resten der Resistschicht ausgeführt wird. Damit begrenzen sowohl die Schutzschicht als auch das Resist den Bereich, in dem die a-nodische Oxidation selektiv durchgeführt wird. Bei einer Ausgestaltung besteht die Grundelektrode aus einem Ventilmetall oder einer Ventilmetalllegierung. Alternativ enthält die Grundelektrodenschicht ein Ventilmetall oder eine Ventilmetalllegierung. Insbesondere bei der anodischen Oxidation von Ventilmetallen ist der Schutz des Ventilmetalls bzw. der Ventilmetalllegierung vor dem Durchführen der anodischen Oxidation entscheidend für die Qualität des Oxids.

Es werden nach der Oxidation die Reste der Resistschicht entfernt. Nach dem Entfernen der Reste der Resistschicht wird die Deckelektrodenschicht hergestellt, beispielsweise abgeschieden. Die Deckelektrodenschicht wird mit einem Resistverfahren strukturiert, wobei die Grundschicht freigelegt wird. Wird nur die Grundschicht freigelegt, d.h. die Grundelektrodenschicht ist nicht angegriffen, so können keine Polymerbrücken zwischen den Elektroden des Kondensators beim Ätzen entstehen.

Bei einer anderen Weiterbildung wird nach dem Strukturieren der Deckelektrodenschicht eine Deckelektroden-Schutzschicht hergestellt. Die Deckelektroden-Schutzschicht schützt wiederum vor Kriech- und Leckströmen und hat zudem eine Wirkung als Ätzstoppschicht beim Ätzen von Anschlüssen für die Grundelektrode und/oder für die Deckelektrode. Die DeckelektrodenSchutzschicht wird mit einem Resistverfahren gemeinsam mit der Grundelektrodenschicht strukturiert. Erbringt die Deckelektroden-Schutzschicht eine Schutzwirkung, so verhindert sie, dass flüssiger Fotolack oder Entwickler zum Entwickeln des Fotolacks an die empfindliche Grundelektrodenschicht gelangt, und bspw. später erzeugte Anschlüsse schlechten Kontakt zur Grundelektrodenschicht haben bzw. erst aufwendige Reinigungsschritte zum Reinigen der Kontaktflächen erforderlich sind.

Im Folgenden werden Ausführungsbeispiele der Erfindung an Hand der beiliegenden Figuren erläutert. Darin zeigen:
- Figur 1: eine integrierte Schaltungsanordnung mit Kondensator und mit Präzisionswiderstand, und
- Figuren 2 bis 4: Herstellungsstufen bei der Herstellung der integrierten Schaltungsanordnung.

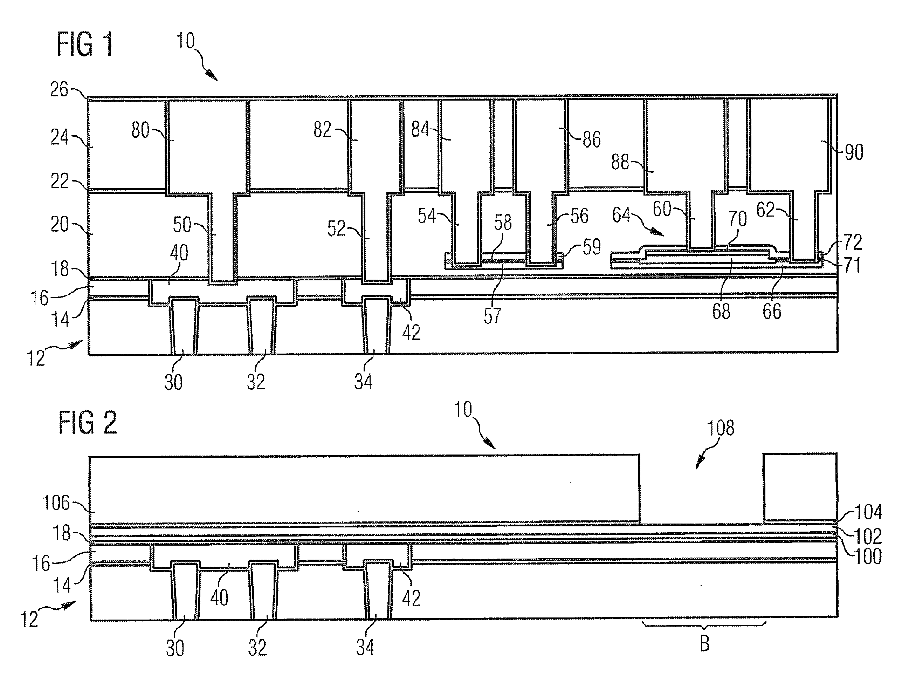

Figur 1 zeigt eine integrierte Schaltungsanordnung 10, die in der Reihenfolge von einem nicht dargestellten Siliziumsubstrat die folgenden Schichten enthält:
- eine ebene Kontaktlage 12 mit einer Dicke von beispielsweise 300 nm,
- eine Siliziumnitridschicht 14 mit einer Dicke von beispielsweise 50 nm,
- eine Leitbahnlage 16 mit einer Dicke von beispielsweise 200 nm,
- eine Siliziumnitridschicht 18 mit einer Dicke von beispielsweise 50 nm,
- eine Via-Lage 20 mit einer Dicke von beispielsweise 500 nm,
- eine Siliziumnitridschicht 22 mit einer Dicke von beispielsweise 50 nm,
- eine Leitbahnlage 24 mit einer Schichtdicke von beispielsweise ebenfalls 500 nm, und
- eine Siliziumnitridschicht 26 mit einer Dicke von beispielsweise 50 nm.

Die Siliziumnitridschichten 14, 18, 22 und 26 dienen sowohl als Ätzstoppschichten als auch als Diffusionsbarriere, die die Diffusion von Kupfer zu dem Substrat verhindern sollen.

In der Kontaktlage 12 sind eine Vielzahl von Kontakten angeordnet, die zum Halbleitersubstrat oder zu polykristallinem Silizium führen. Im Ausführungsbeispiel sind die Kontakte aus Wolfram, siehe beispielsweise drei Kontakte 30 bis 34, welche die Kontaktlage 12 durchdringen.

In der Leitbahnlage 40 befinden sich eine Vielzahl von Kupferleitbahnen, an deren Seitenwänden und an deren Böden sich eine Diffusions-Barriere- bzw. Haftschicht (Linerschicht) befindet, beispielsweise aus Tantal oder Tantalnitrid. Die Linerschichten haben üblicherweise eine Dicke kleiner als 50 nm. In der Leitbahnlage 16 ist eine Leitbahn 40 dargestellt, die die Kontakte 30 und 32 verbindet. Außerdem ist in der Leitbahnebene 16 eine Leitstruktur 42 dargestellt, die zum Anschluss des Kontaktes 34 dient.

In der Via-Lage 20 sind eine Vielzahl von Vias angeordnet, die dem vertikalen Stromtransport dienen. So führt ein Via 50 zu der Leitbahn 40. Ein Via 52 führt zu der Leitstruktur 42. Die Vias 50 und 52 durchdringen die Via-Lage 20. Zwei weitere Vias 54 und 56 bilden die Anschlüsse eines Präzisionswiderstandes 57, der von einem Grundschichtabschnitt 58 und einem Schutzschichtabschnitt 59 bedeckt wird. Beide Abschnitte 58 und 59 bestehen bspw. aus Siliziumnitrid.

Zwei weitere Vias 60 und 62 dienen zum Anschluss eines Kondensators 64. Der Kondensator 64 enthält eine substratnahe Grundelektrode 66, ein Dielektrikum 68 und eine Deckelektrode 70. Der Kondensator 64 ist ein sogenannter MIM-Kondensator (Metall-Isolator-Metall). Im Ausführungsbeispiel besteht die Grundelektrode 66 aus Tantalnitrid, das Dielektrikum 68 aus Tantaloxid und die Deckelektrode 70 aus Tantal. Die Grundelektrode hat beispielsweise eine Dicke kleiner 100 nm, bspw. eine Dicke von 80 nm. Das Dielektrikum 68 hat eine Dicke von beispielsweise 50 nm. Die Deckelektrode 70 hat beispielsweise eine Dicke von 30 nm. Das Via 60 dient zum Anschluss der Deckelektrode 70. Das Via 62 dient dagegen zum Anschluss der Grundelektrode 66. Der Kondensator 64 ist ebenfalls von einem Grundschichtabschnitt 71 und einem Schutzschichtabschnitt 72 bedeckt. Beide Abschnitte 71 und 72 bestehen bspw. aus Siliziumnitrid.

Der Präzisionswiderstand 57 und der Kondensator 64 sind voneinander durch Isoliermaterial der Via-Lage 20 getrennt, beispielsweise durch Siliziumdioxid. Zwischen dem Präzisionswiderstand 57 und der Siliziumnitridschicht 18 sowie zwischen dem Kondensator 64 und der Siliziumnitridschicht 18 befindet sich eine dünne Isolierschicht 100, beispielsweise aus Siliziumdioxid, mit einer Dicke von beispielsweise kleiner 100 nm, bspw. von 50 nm. Die Vias 50 bis 56 bzw. 60 und 62 sind an ihren Seitenwänden und an ihren Böden ebenfalls mit einer Barriere- bzw. Haftschicht bedeckt, beispielsweise einem Tantalnitridliner.

In der Leitbahnlage 24 sind eine Vielzahl von Leitbahnen zum lateralen Stromtransport und mehrere Leitstrukturen 80 bis 90 angeordnet, die zur einerseits vertikalen aber überwiegend lateralen Stromleitung dienen. Die Leitstruktur 80 dient zum Anschluss des Vias 50. Die Leitstruktur 82 dient zum Anschluss des Vias 52. Die Leitstrukturen 84 und 86 dienen zum Anschluss des Vias 54 bzw. des Vias 56, d.h. zum Anschluss des Präzisionswiderstandes 57. Die Leitstrukturen 88 und 90 dienen dagegen zum Anschluss des Vias 60 bzw. 62 und damit zum Anschluss des Kondensators 64. Die Leitstrukturen 80 bis 90 durchdringen die Leitbahnlage 24 und die Siliziumnitridschicht 22. An den Seitenwänden der Leitstrukturen 80 bis 90 ist ebenfalls eine Barriere- bzw. Haftschicht angeordnet. Auch an den Böden der Leitstrukturen 80 bis 90 ist in Bereichen, an denen keine Überlappung zu Vias 52 bis 62 besteht, eine Barriere- bzw. Haftschicht angeordnet.

Im Ausführungsbeispiel bestehen die Leitbahnen 40, 42, die Vias 50 bis 56 bzw. 60 und 62 sowie die Leitstrukturen 80 bis 90 aus Kupfer bzw. einer Kupferlegierung. Alternativ können andere leitfähige Materialien verwendet werden, z.B. Aluminium, Wolfram, Gold oder Silber bzw. Legierungen. Als Isolationsmaterial in der Kontaktlage 12, in der Leitbahnlage 16, in der Via-Lage 20 und in der Leitbahnlage 24 wird Siliziumdioxid verwendet. Alternativ wird ein Material mit einer geringeren Dielektrizitätskonstante als Siliziumdioxid verwendet, d.h. ein sogenanntes low k-Material. Insbesondere beim Verwenden von Material mit einer kleinen Dielektrizitätskonstante lässt sich an Stelle der Siliziumnitridschichten 14, 18, 22 und 24 auch Siliziumkarbid oder ein Material verwenden, das Silizium, Kohlenstoff und Stickstoff enthält.

Die Herstellung der Schaltungsanordnung 10 wird im Folgenden an Hand der Figuren 2 bis 4 näher erläutert. Die Herstellung der Kontaktlage 12, der Siliziumnitridschicht 14, der Leitbahnlage 16 und der Siliziumnitridschicht 18 erfolgt auf übliche Art und Weise, so dass die dabei ausgeführten Prozessschritte nicht näher erläutert werden. Nach dem ganzflächigen Abscheiden der Siliziumnitridschicht 18, beispielsweise mit Hilfe eines CVD-Prozesses (Chemical Vapor Deposition) wird ganzflächig eine dünne Siliziumdioxidschicht 100 abgeschieden, die den Abstand des Präzisionswiderstandes 57 bzw. des Kondensators 54 von der Siliziumnitridschicht 18 und damit letztlich auch vom Substrat festlegt. Beispielsweise wird die Siliziumdioxidschicht 100 mit einem CVD-Verfahren erzeugt. Nachdem die Siliziumdioxidschicht 100 abgeschieden worden ist, wird ganzflächig eine Tantalnitridschicht 102 abgeschieden, beispielsweise durch Sputtern und beispielsweise mit einer Dicke von 80 nm. Alternativ lässt sich eine Tantalschicht oder eine Schicht aus einem anderen oxidierbaren Material abscheiden.

Nach der ganzflächigen Abscheidung der Tantalnitridschicht 102 wird eine Grundschicht 104 abgeschieden, die die Tantalnitridschicht 102 vor Fotolack und Entwickler schützt, wie nachfolgend noch erläutert wird. Die Grundschicht 104 wird bspw. in einer Schichtdicke von 50 nm (Nanometer) abgeschieden. Als Material der Grundschicht 104 dient bspw. Siliziumnitrid.

Auf die noch unstrukturierte Siliziumnitrid-Grundschicht 104 wird ganzflächig eine Fotolackschicht 106 aufgebracht, beispielsweise durch Aufschleudern. Die Fotolackschicht 106 wird selektiv belichtet und entwickelt, wobei an der Stelle, an der das Dielektrikum 68 erzeugt werden soll, eine Aussparung 108 entsteht, deren Boden nach dem Entwickeln noch auf der Siliziumnitrid-Grundschicht 104 liegt. Mit anderen Worten ist die Grundschicht 104 nach dem Entwickeln noch unstrukturiert.

Anschließend wird beispielsweise mit Hilfe eines Plasmaätzprozesses die Siliziumnitrid-Grundschicht 104 am Boden der Aussparung 108 entfernt, so dass ein Bereich B der Tantalnitridschicht 102 freigelegt wird. Ebenso muß der Kontaktbereich der Elektrodenanschlüsse am Waferrand für die anodische Oxidation freigelegt werden.

Anschließend wird selektiv nur in der Aussparung 108 eine anodische Oxidation der Tantalnitridschicht 102 zum Erzeugen des Dielektrikums 68 durchgeführt. Der Pluspol einer Gleichspannung wird am Rand der integrierten Schaltungsanordnung bzw. eines Wafers, der die integrierte Schaltungsanordnung 10 enthält, mit dem Pluspol einer Gleichspannungsquelle verbunden, beispielsweise unter Verwendung eines abgedichteten Kontaktes. Die Abdichtung dient zum Schutz des Kontaktbereichs vor der anodischen Oxidation des Randbereichs. Der negative Pol der Gleichspannungsquelle wird über eine Leitung mit einer Tantalelektrode oder mit einer Tantalnitridelektrode verbunden. Die Elektroden könne wahlweise auch aus Platin oder einem anderen Material bestehen. Die Elektrode und die Schaltungsanordnung 10 werden in ein Becken eingetaucht, in welchem sich eine geeignete Elektrolytlösung befindet, beispielsweise Phosphorsäure oder Zitronensäure. In der Aussparung 108 wird das Dielektrikum 68 beispielsweise durch Anlegen eines konstanten Stroms bis zum Anliegen einer definierten Maximalspannung aufgewachsen. Dies entspricht der definierten Dielektrikumszielschichtdicke. In der folgenden Ausheilungsphase wird die Spannung auf diesem Maximalwert konstant gehalten. In dieser Phase nimmt der Stromfluss kontinuierlich ab und dient lediglich dem Ausheilen der Schicht und dem Schließen noch vorhandener Diffusionspfade. In dieser Phase erfolgt im wesentlichen kein Dielektrikumsschichtdickenzuwachs mehr.

Die Dicke des Dielektrikums wird durch die Maximalspannung bestimmt, die bspw. 100 Volt beträgt. Bspw. vergeht vom Beginn der anodischen Oxidation bis zum Erreichen der Maximalspannung eine halbe Stunde.

Die integrierte Schaltungsanordnung 10 wird nach dem Oxidieren des Dielektrikums 68 aus dem Becken entnommen. Der elektrische Anschluss im Randbereich des Wafers bzw. der Schaltungsanordnung wird wieder entfernt. Danach werden die nach dem Entwickeln verbliebenen Reste der Fotolackschicht 106 entfernt.

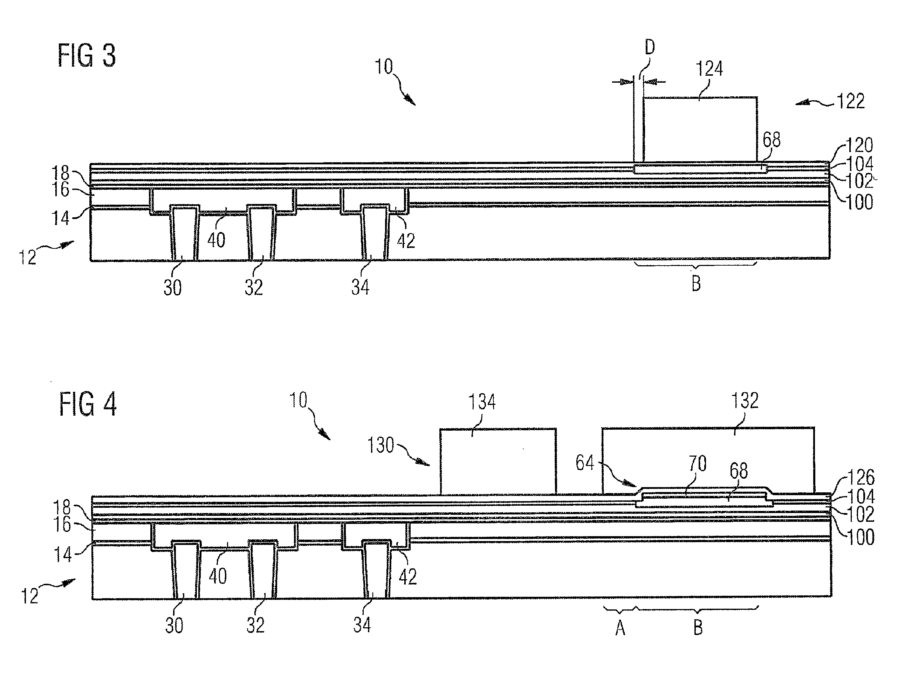

Wie in Figur 3 dargestellt, wird anschließend eine Deckelektrodenschicht 120 abgeschieden, die im Ausführungsbeispiel aus Tantal besteht. Bei anderen Ausführungsbeispielen wird Titan, Aluminium, Tantalnitrid oder Titannitrid als Material für die Deckelektrodenschicht 120 verwendet.

Auf die noch unstrukturierte Deckelektrodenschicht 120 wird eine Fotolackschicht 122 aufgebracht, selektiv belichtet und entwickelt, wobei oberhalb des Bereiches B eine rechteckförmige oder quadratische Lackstruktur 124 verbleibt. Die Lackstruktur 124 ist so bemessen, dass der Bereich B nicht vollständig bedeckt wird, beispielsweise gibt es einen umlaufenden Rand D von beispielsweise 100 nm, der nicht von der Lackstruktur 124 bedeckt wird.

Anschließend wird die Deckelektrodenschicht 120 gemäß der Lackstruktur 124 strukturiert, beispielsweise mit Hilfe eines Plasmaätzens, bei dem im Randbereich des Dielektrikums 68 eine Stufe entsteht, weil in der Siliziumnitrid-Grundschicht 104 gestoppt wird, über deren substratferne Oberfläche das Dielektrikum 68 im Ausführungsbeispiel bereits vor dem reaktiven Ionenätzen hinausragt. Beispielsweise wird die Hälfte der Schichtdicke der Siliziumnitrid-Grundschicht 104 abgetragen. Demzufolge wird die unter der Siliziumnitrid-Grundschicht 104 angeordnete Tantalnitridschicht 102 beim Strukturieren der Deckelektrodenschicht 120 nicht freigelegt, so dass die Bildung von Polymerbrücken zwischen den Elektroden des Kondensators 64 vermieden wird. Enthalten diese Polymere Metalleinlagerungen, so würden Kurzschlüsse oder Kriechströme entstehen.

Wie in Figur 4 dargestellt, wird nach dem Strukturieren der Deckelektrode 70 und dem Entfernen der Lackstruktur 124 eine Deckelektrodenschutzschicht 126 abgeschieden, beispielsweise mit Hilfe eines CVD-Verfahrens. Die Schutzschicht 126 besteht bspw. aus Siliziumnitrid.

Auf die noch unstrukturierte Schutzschicht 126 wird eine Fotolackschicht 130 aufgebracht, selektiv belichtet und strukturiert, wobei unter anderem zwei Fotolackstrukturen 132 und 134 erzeugt werden. Die Fotolackstruktur 132 liegt oberhalb des Bereiches B und überragt den Bereich B an einem umlaufenden Rand um einen Abstand A von beispielsweise 400 nm. Der Rand ist zumindest einseitig so zu definieren, dass in den überragenden Bereich das Via 62 platziert werden kann.

Die Fotolackstruktur 134 liegt im Ausführungsbeispiel links neben der Fotolackstruktur 132 und legt einen Bereich fest, in dem der Präzisionswiderstand 57 erzeugt werden soll.

Wie wiederum aus Figur 1 zu erkennen ist, werden der Präzisionswiderstand 57 und die Grundelektrode 66 anschließend gemäß den Fotolackstrukturen 132 und 134 strukturiert, beispielsweise mit Hilfe eines Plasmaätzverfahrens. Dabei wird in der Siliziumdioxidschicht 100 gestoppt. Aus der Tantalnitridschicht 102 entstehen dabei der Präzisionswiderstand 57 und die Grundelektrode 66 des Kondensators 64. Aus der bereits gedünnten und mit der Aussparung 108 vorstrukturierten Siliziumnitrid-Schutzschicht 102 entstehen die Grundschichtabschnitte 58 und 71. Aus der bei der Grundelektrodenätzung strukturierten Schutzschicht 126 entstehen die Schutzschichtabschnitte 59 und 72.

Anschließend wird das Siliziumdioxid der Via-Lage 20 aufgebracht, beispielsweise mit Hilfe eines Plasma-CVD-Prozesses. Das Siliziumdioxid der Via-Lage 20 kann planarisiert werden, beispielsweise mit Hilfe eines CMP-Verfahrens (Chemical Mechanical Polishing). Anschließend wird die Siliziumnitridschicht 22 abgeschieden. Danach wird eine Siliziumdioxidschicht abgeschieden, die die Isolierung der Leitbahnlage 24 bildet. Danach werden im Rahmen eines Dual-Damascene-Verfahrens die Vias 50 bis 56, 60 und 62 sowie die Leitstrukturen 80 bis 90 erzeugt. Beispielsweise wird nach dem Öffnen von Aussparungen in der Via-Lage 20 und in der Leitbahn-Lage 24 und nach dem Aufsputtern des Liners eine dünne Kupferschicht aufgesputtert. Anschließend werden die Kupferkerne der Vias 50 bis 56 und 60, 62 sowie der Leitstrukturen 80 bis 90 mit Hilfe eines galvanischen Verfahrens erzeugt.

Anschließend wird ein Planarisieren durchgeführt, beispielsweise mit Hilfe eines CMP-Verfahrens. Danach wird die Siliziumnitridschicht 26 abgeschieden und es werden weitere Metallisierungslagen hergestellt. Bei einem anderen Ausführungsbeispiel ist die Leitbahnlage 24 die äußere Metallisierungslage, so dass nach dem Herstellen der Leitbahnlage 24 äußere Anschlüsse an die Schaltungsanordnung 10 angebracht werden.

Das erläuterte Verfahren wird bei einem anderen Ausführungsbeispiel bei einer durch reaktives Ionenätzen erzeugten Metallisierung, z.B. aus Aluminium, durchgeführt. Während der Erzeugung des Präzisionswiderstandes 57 und des MIM-Kondensators 64 sind die Aluminiumleitstrukturen mit einem Oxid abgedeckt und die Isolierung zwischen den Aluminiumleitstrukturen ist planarisiert.

Bei einem nicht beanspruchten Beispiel wird die Grundschicht 104 beim Strukturieren der Deckelektrode 70 vollständig entfernt, so dass beispielsweise auf der Tantalnitridschicht 102 gestoppt wird.

Bei einem weiteren nicht beanspruchten Beispiel überrargt die Lackstruktur 124 den Bereich B an ihrem Umfang um eine vorgegebene Distanz.

Bei einem anderen Ausführungsbeispiel wird die Tantalnitridschicht 102 in Aussparungen der Siliziumnitridschicht 18 abgeschieden, so dass die Grundelektrode 66 des Kondensators auch von unten her angeschlossen werden kann.

Bei einem anderen Ausführungsbeispiel wird die Fotolackschicht 106 bereits nach Strukturierung der Grundschicht 104 vor der anodischen Oxidation entfernt.

Bei dem erläuterten Verfahren werden der Präzisionswiderstand 57 und der Kondensator 64 simultan gefertigt, d.h. unter Verwendung einer Vielzahl von Prozessschritten, bei denen Bestandteile des Präzisionswiderstandes 57 bzw. des Kondensators 64 gleichzeitig hergestellt werden. Durch diese Vorgehensweise ergeben sich zahlreiche Vorteile:
- Beide passive Bauelemente lassen sich mit einer deutlich verringerten Anzahl von Fotoebenen und Prozessschritten herstellen. Im Vergleich zu einer Variante, bei der die passiven Bauelemente in verschiedenen Ebenen angeordnet sind, lässt sich eine Oxidschicht und eine zur Planarisierung dieser Oxidschicht verwendete CMP-Planarisierung einsparen, wodurch der Herstellungsaufwand erheblich sinkt.
- Auf Grund einer stromgetriebenen bzw. spannungsgetriebenen und einfach steuerbaren Diffusionsreaktion beim anodischen Oxidieren hat das Dielektrikum 68 eine hohe Qualität mit einem höheren Dielektrizitätswert und einer höheren Durchbruchsspannung als abgeschiedene Dielektrika. Die Schichtqualität ist in einem sehr weiten Bereich kontrollierbar und steuerbar über den Stromverlauf bzw. über den Spannungsverlauf beim anodischen Oxidieren.
- Die anodische Oxidation des Dielektrikums 68 lässt sich auch unabhängig von der Herstellung eines Präzisionswiderstandes 57 durchführen, d.h. in einer Schaltungsanordnung, die keine Präzisionswiderstände 57 enthält.
- Im Vergleich zu Tantaloxidabscheidungen entsteht ein sehr einfacher, schnellerer und preiswerter Prozess.
- Die Herstellung des Präzisionswiderstandes 57 kann im Vergleich zu der Herstellung von Präzisionswiderstand und Kondensator in verschiedenen Ebenen beibehalten werden.
- Beim Verwenden einer anodischen Oxidation gibt es eine sogenannte "Selbstheilung" von Defekten im Dielektrikum 68, da an leitenden Stellen ein zusätzliches Oxid wächst, beispielsweise werden Tantalnitridspitzen beim Aufwachsen des Dielektrikums 68 in Oxid umgewandelt.

Durch den Einsatz einer selektiven anodischen Oxidation des Kondensatordielektrikums lässt sich also ein sehr hochwertiger Kondensator 64 und damit eine sehr hochwertige integrierte Schaltungsanordnung 10 erzeugen. Die Tantalnitridschicht 102 lässt sich gleichzeitig als Präzisionswiderstand 57 und als Grundelektrode 66 des Kondensators 64 und anodisch oxidiert als Dielektrikum verwenden.

## Patentansprüche

1. Verfahren zum Herstellen eines Kondensators (64), mit den Verfahrensschritten:
Erzeugen einer elektrisch leitfähigen Grundelektrodenschicht (102),
Erzeugen einer elektrisch isolierenden Grundschicht (104) nach dem Erzeugen der Grundelektrodenschicht (102),
Aufbringen einer Resistschicht (106) auf die Grundschicht (104),
selektives Bestrahlen und Entwickeln der Resistschicht (106),
Strukturieren der Grundschicht (104) mit der entwickelten Resistschicht (106), wobei die Grundelektrodenschicht (102) in mindestens einem Bereich (B) gemäß der entwickelten Resistschicht (106) freigelegt wird,
Durchführen einer anodischen Oxidation der Grundelektrodenschicht (102) in dem mindestens einem freiliegenden Bereich (B) der Grundelektrodenschicht (102) nach dem Strukturieren der Grundschicht (104) zum Erzeugen des Dielektrikums (68) des Kondensators,
wobei die Grundelektrodenschicht (102) noch unstrukturiert ist beim Erzeugen der Grundschicht (104),
und wobei die Grundschicht (104) die Funktion einer Schutzschicht hat, die verhindert, dass weder flüssiges Resist noch Entwickler zum Entwickeln des Resists an ein Metall der Grundelektrodenschicht (102) kommt vor dem Durchführen der anodischen Oxidation,
wobei die Reste der Resistschicht (106) entfernt werden,
wobei nach dem Entfernen der Reste der Resistschicht (106) eine Deckelektrodenschicht (120) hergestellt wird,
und wobei die Deckelektrodenschicht (120) mit einem Resistverfahren (122) strukturiert wird,
**dadurch gekennzeichnet, dass**
die Grundschicht (71) dünner als das Dielektrikum (68) ist,
dass zur Strukturierung der Deckelektrodenschicht (120) eine Fotolackschicht (122, 124) verwendet wird, die oberhalb des freiliegenden Bereiches (B) der Grundelektrodenschicht (102) verbleibt, diesen Bereich (B) aber nicht vollständig bedeckt,
dass die Strukturierung der Deckelektrodenschicht (120) in der Grundschicht (104) stoppt und somit die Grundschicht (104) freilegt, wobei das Dielektrikum (68) vor der Strukturierung über die substratferne Oberfläche der Grundschicht (104) hinausragt, so dass bei der Strukturierung eine Stufe im Randbereich des Dielektrikums (68) entsteht,
so dass eine parallel zur Grundelektrodenschicht (102) liegende Stufenfläche des Dielektrikums mit der substratfernen Oberfläche der Grundschicht (104) in einer Ebene liegt,
und dass beim Strukturieren der Deckelektrodenschicht (120) die unter der Grundschicht (104) angeordnete Grundelektrodenschicht (102) nicht freigelegt wird.

2. Verfahren nach Anspruch 1, **dadurch gekenn - zeichnet,** dass die anodische Oxidation vor oder nach dem Entfernen von nach dem Entwickeln verbliebenen Resten der Resistschicht (106) ausgeführt wird,
und/oder dass als Material der Grundelektrodenschicht ein Ventilmetall oder eine Ventilmetalllegierung verwendet wird.

3. Verfahren nach Anspruch 1 oder 2, **dadurch gekennzeichnet, dass** nach dem Strukturieren der Deckelektrodenschicht (120) eine Deckelektroden-Schutzschicht (126) oder eine Ätzstoppschicht hergestellt wird,
und dass die Deckelektroden-Schutzschicht (126) oder die Ätzstoppschicht mit einem Resistverfahren (132, 134) gemeinsam mit der Grundelektrodenschicht (102) strukturiert wird.

## Claims

1. Method for producing a capacitor (64), comprising the method steps of:
producing an electrically conductive base electrode layer (102),
producing an electrically insulating base layer (104) after the base electrode layer (102) has been produced,
applying a resist layer (106) to the base layer (104),
selectively irradiating and developing the resist layer (106),
patterning the base layer (104) with the developed resist layer (106), the base electrode layer (102) being uncovered in at least one region (B) in accordance with the developed resist layer (106),
carrying out an anodic oxidation of the base electrode layer (102) in the at least one uncovered region (B) of the base electrode layer (102) after the base layer (104) has been patterned to produce the dielectric (68) of the capacitor,
the base electrode layer (102) still being in its unpatterned state as the base layer (104) is being produced,
and the base layer (104) having the function of a protective layer, which prevents either liquid resist or developer used for developing the resist from reaching a metal of the base electrode layer (102) before the anodic oxidation is carried out, the residues of the resist layer (106) being removed,
a covering electrode layer (120) being produced after the residues of the resist layer (106) have been removed,
and the covering electrode layer (120) being patterned using a resist method (122),
**characterized in that**
the base layer (71) is thinner than the dielectric (68),
**in that** the covering electrode layer (120) is patterned using a photoresist layer (122, 124), which remains above the uncovered region (B) of the base electrode layer (102) but does not completely cover said region (B),
**in that** the patterning of the covering electrode layer (120) stops in the base layer (104) and therefore uncovers the base layer (104), the dielectric (68) projecting beyond that surface of the base layer (104) which is remote from the substrate before the patterning, such that a step is formed in the edge region of the dielectric (68) during the patterning, and therefore a step face of the dielectric lying parallel to the base electrode layer (102) lies in a plane with that surface of the base layer (104) which is remote from the substrate,
and **in that** the base electrode layer (102) arranged underneath the base layer (104) is not uncovered as the covering electrode layer (120) is being patterned.

2. Method according to Claim 1, **characterized in that** the anodic oxidation is carried out before or after the removal of residues of the resist layer (106) which have remained after the developing, and/or **in that** a valve metal or a valve metal alloy is used as material of the base electrode layer.

3. Method according to Claim 1 or 2, **characterized in that** a covering electrode protective layer (126) or an etching stop layer is produced after the covering electrode layer (120) has been patterned, and **in that** the covering electrode protective layer (126) or the etching stop layer is patterned together with the base electrode layer (102) using a resist method (132, 134).

## Revendications

1. Procédé de fabrication d'un condensateur (64), comprenant les étapes suivantes:
- produire une couche d'électrode de base électriquement conductrice (102),
- produire une couche de base électriquement isolante (104) après la production de la couche d'électrode de base (102),
- déposer une couche de résine photosensible (106) sur la couche de base (104),
- irradier et développer sélectivement la couche de résine photosensible (106),
- structurer la couche de base (104) avec la couche de résine photosensible développée (106), la couche d'électrode de base (102) étant exposée au moins dans une zone (B) selon la couche de résine photosensible développée (106),
- effectuer une oxydation anodique de la couche d'électrode de base (102) dans ladite au moins une zone exposée (B) de la couche d'électrode de base (102) après la structuration de la couche de base (104) afin de produire le diélectrique (68) du condensateur,
- dans lequel la couche d'électrode de base (102) n'est pas encore structurée lors de la production de la couche de base (104),
- et dans lequel la couche de base (104) a la fonction d'une couche de protection, qui empêche que ni la résine photosensible liquide ni le développeur pour le développement de la résine photosensible ne vienne sur un métal de la couche d'électrode de base (102) avant l'exécution de l'oxydation anodique,
- dans lequel on élimine les résidus de la couche de résine photosensible (106),
- dans lequel, après l'élimination des résidus de la couche de résine photosensible (106), on fabrique une couche d'électrode de couverture (120),
- et dans lequel on structure la couche d'électrode de couverture (120) avec un procédé à la résine photosensible (122),
**caractérisé en ce que**
- la couche de base (71) est plus mince que le diélectrique (68),
- pour la structuration de la couche d'électrode de couverture (120), on utilise une couche de laque photosensible (122, 124), qui reste au-dessus de la zone exposée (B) de la couche d'électrode de base (102), mais ne recouvre pas entièrement cette zone (B),
- la structuration de la couche d'électrode de couverture (120) s'arrête dans la couche de base (104) et expose ainsi la couche de base (104), le diélectrique (68) s'étendant avant la structuration sur la surface de la couche de base (104) éloignée du substrat, de telle manière que, lors de la structuration, il apparaisse un palier dans la zone de bord du diélectrique (68), de telle manière qu'une face de palier du diélectrique située parallèlement à la couche d'électrode de base (102) soit située dans un plan avec la surface de la couche de base (104) éloignée du substrat,
- et, lors de la structuration de la couche d'électrode de couverture (120), la couche d'électrode de base (102) disposée en dessous de la couche de base (104) n'est pas exposée.

2. Procédé selon la revendication 1, **caractérisé en ce que** l'on effectue l'oxydation anodique avant ou après l'élimination de résidus de la couche de résine photosensible (106) restant après le développement, et/ou l'on utilise comme matériau de la couche d'électrode de base un métal de soupape ou un alliage métallique de soupape.

3. Procédé selon la revendication 1 ou 2, **caractérisé en ce que**, après la structuration de la couche d'électrode de couverture (120), on fabrique une couche de protection de l'électrode de couverture (126) ou une couche d'arrêt de gravure, et **en ce que** l'on structure la couche de protection de l'électrode de couverture (126) ou la couche d'arrêt de gravure avec un procédé à la résine photosensible (132, 134) en même temps que la couche d'électrode de base (102).
